# FASCICULE DE BREVET EUROPEEN

(11) **EP 3 830 311 B1**
(45) Date de publication et mention de la délivrance du brevet: **01.06.2022**
(21) Numéro de dépôt: 19759647.1
(22) Date de dépôt: 24.07.2019
(51) Int. Cl.: C23C 16/04, C23C 16/458, C23C 16/46, C04B 35/83, C23C 16/455, C04B 41/45

(54) **PROCEDE DE DENSIFICATION PAR INFILTRATION CHIMIQUE EN PHASE GAZEUSE DE SUBSTRATS ANNULAIRES POREUX**
VERFAHREN ZUR VERDICHTUNG PORÖSER RINGFÖRMIGER SUBSTRATE DURCH CHEMISCHE GASPHASENINFILTRATION
METHOD FOR DENSIFYING POROUS ANNULAR SUBSTRATES BY CHEMICAL VAPOUR INFILTRATION

(30) Priorité: 03.08.2018 FR 1857284
(43) Date de publication de la demande: 09.06.2021
(73) Titulaire: Safran Ceramics, 33185 Le Haillan (FR)
(72) Inventeur: LAMOUROUX, Franck, 77550 Moissy-Cramayel (FR); DUPONT, Rémy, 77550 Moissy-Cramayel (FR); ROS, William, 77550 Moissy-Cramayel (FR)
(74) Mandataire: Cabinet Beau de Loménie
(86) Numéro de dépôt international: PCT/FR2019/051829
(87) Numéro de publication internationale: WO 2020/025879

(56) Documents cités:
- EP-A2- 1 285 976
- US-A1- 2007 014 990

## Description

### Arrière-plan de l'invention

La présente invention se rapporte au domaine général des procédés de densification par infiltration chimique en phase gazeuse (CVI) de substrats annulaires poreux.

Pour densifier de tels substrats, on connait notamment des procédés dans lesquels on dispose des piles de substrats dans l'enceinte chauffée d'une installation de densification, et on introduit une phase gazeuse comprenant un précurseur de matériau de matrice à l'intérieur des piles de substrats de façon à former la matrice dans la porosité des substrats. Le document FR 2834713 décrit un tel procédé et une installation pour sa mise en œuvre. Le document US 2007/014990 décrit également un procédé de densification de substrats poreux.

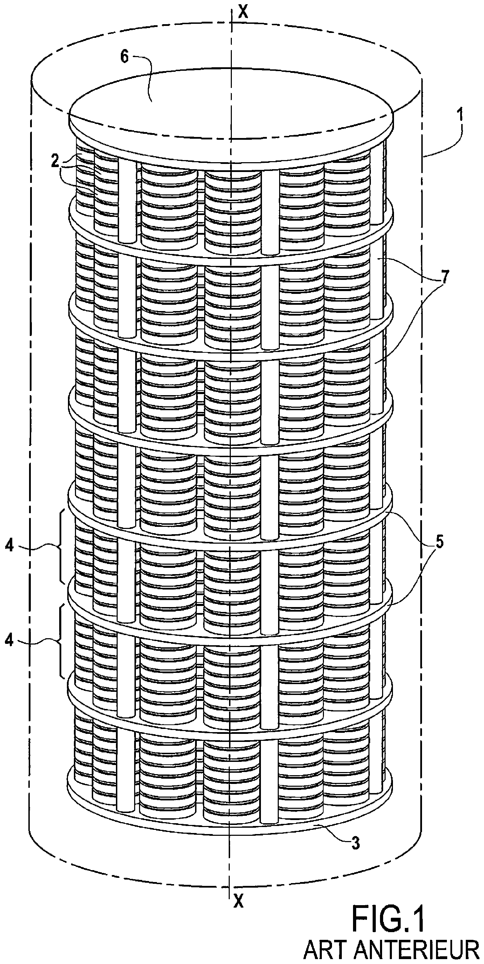

Lorsque l'on souhaite densifier un nombre important de piles de substrats, on utilise généralement une installation de plus grande taille. Un exemple connu de chargement pouvant être utilisé dans l'enceinte 1 d'un four de densification est illustré sur la figure 1. L'enceinte 1 est cylindrique autour d'un axe X. Le chargement comprend une pluralité de piles de substrats annulaires poreux 2 portées par un même plateau support inférieur 3. Chaque pile est formée de plusieurs sections 4 de piles superposées et séparées par des plateaux supports intermédiaires 5 communs à toutes les piles. Les plateaux 3 et 5 comprennent des ouvertures alignées avec des passages centraux des substrats 2 afin de faire circuler dans chaque pile une phase gazeuse réactive qui traversera ensuite les substrats 2 pour les densifier. Un plateau supérieur 6 surmonte le chargement et ferme le volume interne de chaque pile. Les plateaux supports intermédiaires 5 sont maintenus à l'aide de chandelles verticales 7.

Un tel chargement présente plusieurs inconvénients : il est long et complexe à réaliser, des gradients de température peuvent être présents au sein de l'enceinte, et les étanchéités entre les plateaux supports et les sections de piles sont difficiles à garantir. En outre, il est difficile de contrôler le temps de séjour du gaz précurseur qui n'a pas été consommé au sein de l'enceinte, ce qui entraîne la formation d'hydrocarbures aromatiques polycycliques indésirables.

Il existe ainsi un besoin pour un procédé de densification par infiltration chimique en phase gazeuse qui ne présente pas les inconvénients précités.

### Objet et résumé de l'invention

La présente invention a donc pour but principal de pallier de tels inconvénients en proposant un procédé de densification par infiltration chimique en phase gazeuse de substrats annulaires poreux, le procédé comprenant au moins les étapes suivantes :
- fournir une pluralité de modules unitaires, chaque module unitaire comprenant un plateau support sur lequel est formée une pile de substrats annulaires poreux, le plateau support comprenant une ouverture centrale d'admission de gaz communiquant avec un volume interne formé par les passages centraux des substrats empilés et des ouvertures d'évacuation de gaz réparties angulairement autour de l'ouverture centrale, et un cylindre formant masse thermique disposé autour de la pile de substrat ayant une première extrémité solidaire du plateau support et une deuxième extrémité libre,
- former des empilements de modules unitaires dans l'enceinte d'un four de densification, chaque empilement comprenant au moins un deuxième module unitaire empilé sur un premier module unitaire, le plateau support du deuxième module unitaire reposant sur la deuxième extrémité libre du cylindre du premier module unitaire, l'ouverture centrale d'admission de gaz du deuxième module unitaire communiquant avec le volume interne de la pile de substrats du premier module unitaire, et les ouvertures d'évacuation de gaz du deuxième module unitaire communiquant avec un volume externe à la pile de substrats du premier module unitaire, et
- injecter dans les empilements de modules unitaires une phase gazeuse comprenant un précurseur gazeux d'un matériau de matrice à déposer au sein de la porosité des substrats.

Chaque empilement de modules unitaires ainsi réalisé définit un conduit central formé par la réunion des volumes internes des piles de substrats (lesdits volumes communiquent par les ouvertures centrales des plateaux supports), et un conduit périphérique formé par la réunion des volumes externes aux piles de substrats situés à l'intérieur des modules unitaires (lesdits volumes communiquent par les ouvertures d'évacuation des plateaux supports). Le conduit central permet d'acheminer le gaz injecté à l'intérieur de l'empilement et sur toute sa hauteur, alors que le conduit périphérique a pour fonction de récupérer et canaliser le gaz précurseur ayant traversé les substrats pour l'évacuer. Le conduit périphérique ainsi défini permet de canaliser les gaz n'ayant pas réagi plus rapidement pour leur évacuation, par exemple au niveau d'une ouverture d'évacuation présent dans une paroi supérieure de l'enceinte, ce qui limite leur temps de maturation et réduit la quantité d'hydrocarbures polycycliques (HAP) produits par kilogramme de carbone déposé au sein des substrats.

En outre, les cylindres de chaque module unitaire forment des masses thermiques au plus près des piles de substrats, qui permettent une réduction des gradients de température au sein de l'enceinte et améliorent l'homogénéité et la cinétique de densification des substrats. La réduction des écarts de température se traduit inévitablement par une réduction de la durée du cycle de densification et une réduction de la quantité de HAP produits. Dans l'art antérieur, pour limiter l'impact sur la durée du cycle des substrats les moins chauds, on augmente la température dans l'enceinte afin d'obtenir une augmentation de la cinétique en phase homogène. En mettant en œuvre un procédé selon l'invention, le retour à une température plus adaptée permet de réduire de fait le taux de HAP produits.

Dans un tel procédé, il n'est plus nécessaire de contrôler les étanchéités entre des sections de piles et des plateaux supports intermédiaires, mais seulement entre les modules unitaires empilés, ce qui assure une densification plus uniforme des substrats par rapport à des procédés mettant en œuvre un chargement tel que celui décrit en introduction.

Aussi, l'utilisation de grands plateaux de chargement, souvent de forte épaisseur, n'est plus nécessaire avec le procédé selon l'invention. On obtient ainsi un gain en termes de taux de chargement dans l'enceinte.

L'utilisation de tels modules unitaires rend également le placement des substrats à densifier dans l'enceinte plus aisé. En effet, les modules unitaires peuvent être préparés à l'extérieur de l'enceinte du four, puis empilés dans l'enceinte. La formation d'un module unitaire ou des empilements de modules unitaires peut en outre être automatisée.

Dans un exemple de réalisation, chaque empilement de module unitaire peut être supporté uniquement par un fond de l'enceinte du four de densification. En d'autre termes, les empilements de modules unitaires peuvent être indépendants les uns des autres.

Dans un exemple de réalisation, chaque cylindre peut être en graphite.

Dans un exemple de réalisation, chaque module unitaire peut comprendre des cales entre les substrats poreux, chaque cale ménageant un passage de fuite entre le volume interne de la pile de substrats et le volume externe à la pile de substrats. Ainsi, l'invention s'applique notamment à des procédés d'infiltration chimique en phase gazeuse dits à flux forcé, où la phase gazeuse injectée dans une pile traverse les substrats à l'aide de cales pleines positionnées par exemple entre les substrats, qu'à des procédés dits à flux semi-forcé, où des cales ménageant un passage de fuite sont disposées entre les substrats pour forcer une partie seulement de la phase gazeuse à traverser les substrats.

Dans un exemple de réalisation, chaque empilement peut être surmonté par un couvercle fermant un volume constitué par la réunion des volumes internes des piles de substrats dudit empilement, et comprenant des ouvertures en communication avec un volume constitué par la réunion des volumes externes aux piles de substrats dudit empilement. Lesdites ouvertures peuvent être alignées avec les ouvertures d'évacuation de gaz d'un plateau support. Le couvercle peut présenter un diamètre égal au diamètre d'un plateau support.

Dans un exemple de réalisation, chaque plateau support peut être de forme circulaire et présenter un diamètre compris entre 110% et 120% du diamètre externe d'un substrat annulaire poreux.

Dans un exemple de réalisation, pour former une pile de substrats annulaires poreux sur le plateau support d'un module unitaire, on peut insérer des bras d'un dispositif de chargement dans le module unitaire par les ouvertures d'évacuation du plateau support, on peut former la pile de substrats sur les extrémités des bras insérés dans le module unitaire, et on peut retirer les bras du module unitaire de sorte à déposer la pile ainsi formée sur le plateau support. Ces étapes supplémentaires rendent la formation d'une pile de substrats annulaires poreux sur un plateau support plus aisée. Ces étapes peuvent en outre être automatisées.

Dans un exemple de réalisation, l'enceinte du four de densification est délimitée par un suscepteur couplé à un inducteur.

Dans un exemple de réalisation, chaque substrat annulaire poreux peut comprendre du carbone.

Dans un exemple de réalisation, chaque substrat annulaire poreux peut constituer une préforme fibreuse de disque de frein.

### Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :
- la figure 1 montre de façon très schématique un exemple de chargement de substrats annulaires poreux selon l'art antérieur,
- les figures 2 et 3 montrent un exemple de pièce de structure utilisée pour fournir un module unitaire,
- les figures 4A à 4E illustrent des étapes pour former une pile sur le plateau support d'un module unitaire,
- la figure 5 montre de façon très schématique un chargement constitué d'empilements de modules unitaires formés lors de la mise en œuvre d'un procédé selon l'invention,
- la figure 6 montre une vue en coupe d'un empilement de modules unitaires à l'intérieur de l'enceinte d'un four de densification.

### Description détaillée de l'invention

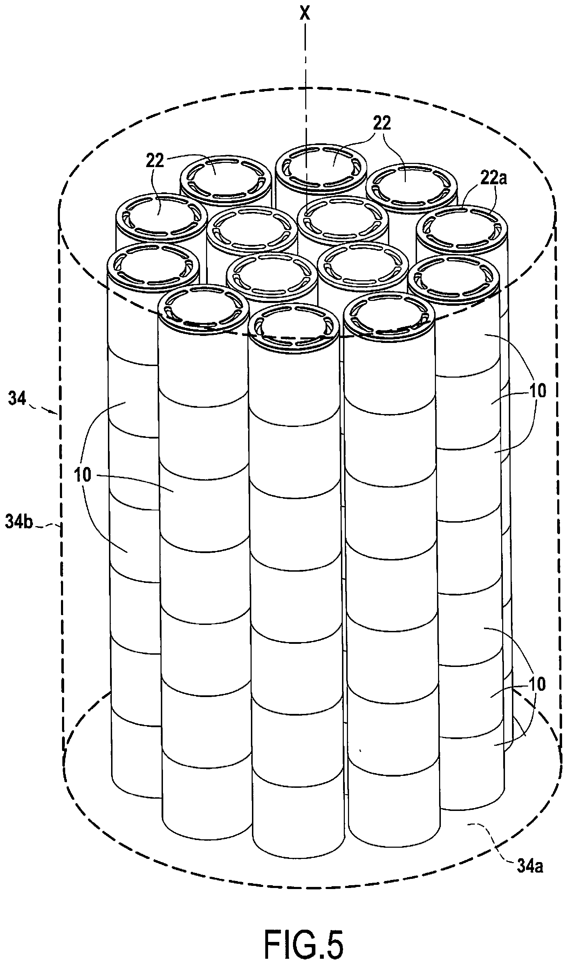

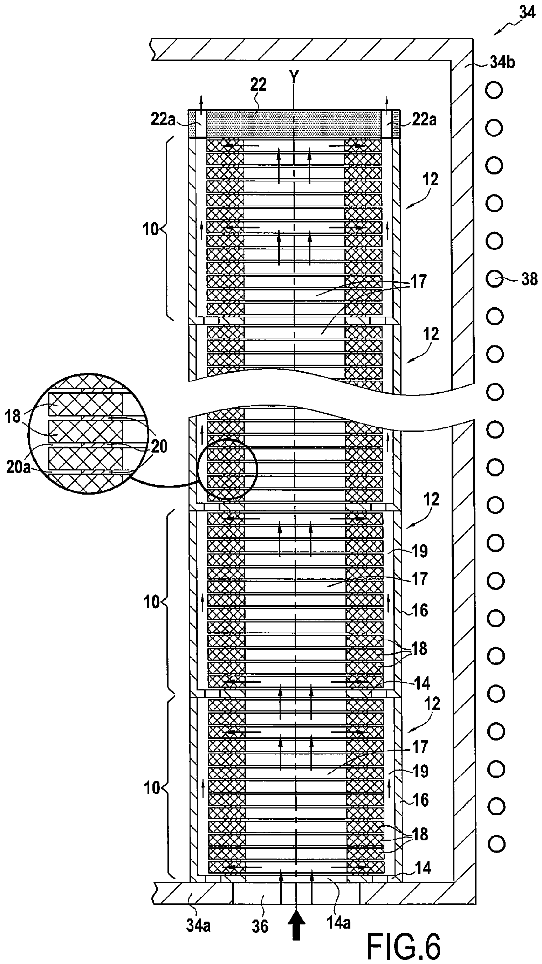

Un procédé de densification par infiltration chimique en phase gazeuse selon l'invention comprend tout d'abord une étape durant laquelle on fournit une pluralité de modules unitaires 10 (figures 5 et 6).

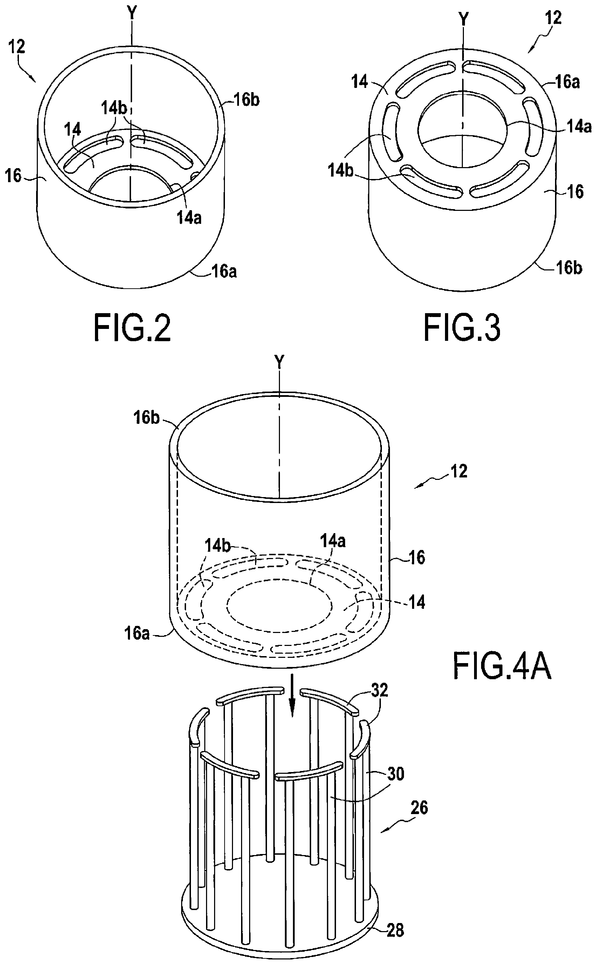

Un module unitaire 10 comprend tout d'abord une pièce de structure 12 (figures 2 et 3) comportant un plateau support 14 muni d'une ouverture centrale d'admission de gaz 14a et d'ouvertures d'évacuation de gaz 14b réparties angulairement autour de l'ouverture centrale 14a. Le plateau support 14 prend ici la forme d'un disque ajouré. Les ouvertures d'évacuation de gaz 14b forment une couronne autour de l'ouverture centrale d'admission 14a, c'est-à-dire décrivent un cercle autour de l'ouverture centrale d'admission 14a. Le plateau support 14 comprend ici six ouvertures d'évacuation de gaz 14b. La pièce de structure 12 comprend en outre un cylindre 16 qui s'étend verticalement à partir du plateau support 14 en étant solidaire de celui-ci. Le cylindre 16 comprend ainsi une première extrémité 16a solidaire du plateau support 14 et une deuxième extrémité libre 16b. Le plateau support 14 et le cylindre 16 sont centrés sur un axe Y. La pièce de structure 12 peut être en graphite afin de récupérer la chaleur issue par exemple d'un inducteur qui assure le chauffage de l'enceinte pour la restituer par rayonnement.

On réalise ensuite un module unitaire 10 en formant une pile de substrats annulaires poreux 18 sur le plateau support 14 de la pièce de structure 12. Chaque substrat annulaire poreux 18 présente un passage central 18a. De façon générale, les substrats annulaires poreux 18 sont empilés sur le plateau support 14 de manière à ce que l'ouverture centrale d'admission 14a communique avec un volume interne 17 formé par les passages centraux 18a des substrats 18 empilés, et que les ouvertures d'évacuation de gaz 14b communiquent avec un volume externe 19 à la pile de substrats 18, le volume externe 19 étant circonscrit à l'intérieur du cylindre 16. Les substrats poreux 18 et la pièce 12 sont centrés sur le même axe Y. Dans cet exemple, les substrats 18 présentent un diamètre externe inférieur à celui du plateau support 14. En particulier, le diamètre du plateau support 14 peut être compris par exemple entre 110% et 120% du diamètre externe d'un substrat 18. Le diamètre de l'ouverture d'admission de gaz 14a peut être de l'ordre du diamètre d'un passage central 18a d'un substrat poreux 18.

Dans l'exemple illustré, un substrat poreux 18 est séparé d'un substrat adjacent ou du plateau support 14 par une ou plusieurs cales d'espacement 20 qui définissent des intervalles 20a (figure 6). Les cales 20, par exemple disposées radialement par rapport à l'axe Y d'un module 10, et sont aménagées pour former des passages faisant communiquer le volume interne 17 empilés avec le volume externe 19.

Les passages ménagés par les cales 20 pourront offrir une section de passage plus ou moins restreinte de manière à permettre l'existence d'un gradient de pression entre les volumes 17 et 19, comme décrit dans la demande de brevet FR 2821859, on parle alors de densification par CVI à flux forcé (section de passage quasi nulle) ou semi-forcé (section de passage non nulle).

Ainsi, chaque module unitaire 10 comprend, dans l'exemple illustré, une pile de substrats 18 entre lesquels sont présentes des cales 20, la pile de substrats 18 étant placée sur une cale 20 au contact du plateau support 14, et étant surmonté par une cale 20 destinée à être au contact d'un autre module unitaire 10 ou d'un couvercle 22 (figures 5 et 6). La longueur du cylindre 16 est ici telle que que l'extrémité libre 16b de celui-ci se termine au même niveau qu'une face supérieure de la dernière cale 20.

Les substrats 18 sont par exemple des préformes en fibres de carbone ou des ébauches formées de préformes pré-densifiées, destinées à la réalisation de disques de frein en matériau composite carbone/carbone (C/C), par densification par une matrice en carbone pyrolytique.

La conception d'un module unitaire 10 selon l'invention permet de former une pile de substrats 18 sur un plateau support 14 d'une façon simple et automatisable. Un exemple de successions d'étapes pour former une pile de substrats 18 sur le plateau support va être décrit en lien avec les figures 4A à 4E.

On peut tout d'abord se munir d'un dispositif de chargement 26 comprenant un plateau inférieur 28 en forme de disque à partir duquel s'étendent des bras verticaux 30. Les bras verticaux 30 sont disposés en cercle à proximité de la circonférence du plateau inférieur 28 et positionnés de façon à ce qu'ils puissent être insérés dans les ouvertures d'évacuation de gaz 14b du plateau support 14 d'une pièce de structure 12. Dans l'exemple illustré, deux bras verticaux adjacents sont reliés à leur extrémité opposée au plateau inférieur 28 par un élément de support de pile 32 qui décrit ici un arc de cercle. La forme de l'élément de support de pile 32 peut correspondre à la forme d'une ouverture d'évacuation de gaz 14b.

Une première étape (figure 4A) consiste à positionner le dispositif de chargement 26 sous la pièce de structure 12 de façon à ce que les bras verticaux 30, et plus précisément les éléments de support de pile 32, soient chacun en regard d'une ouverture d'évacuation 14b.

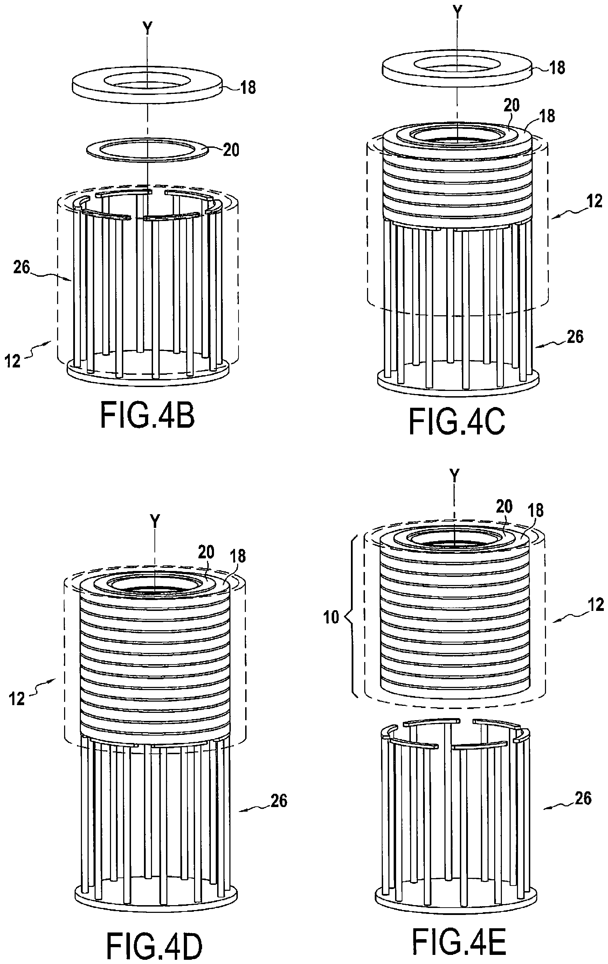

Puis, on insère les bras 30 dans les ouvertures d'évacuation 14b (figure 4B) jusqu'à ce que le plateau inférieur 28 vienne en butée contre le plateau support 14. Le cas échéant, on peut avoir déjà positionné une cale 20 sur le plateau support 14 avant d'insérer les bras 30. Dans l'exemple illustré, la pièce de structure 12 est maintenue par des moyens non représentés indépendants du dispositif de chargement 26 de sorte qu'elle reste fixe et que seul le dispositif de chargement 26 se déplace par rapport à la pièce de structure 12.

On peut alors commencer à former la pile de substrats 18 sur les bras 30, et plus précisément sur les éléments de support de pile 32. Dans l'exemple illustré, le dispositif de chargement 26 est abaissé au fur et à mesure que l'on ajoute un substrat 18 sur la pile (figures 4C et 4D). En variante, la pile de substrats 18 pourrait être formée alors que le dispositif de chargement 26 est fixe.

Enfin, le module unitaire 10, comprenant la pièce de structure 12 et la pile de substrats 18, et éventuellement des cales 20, peut être retiré du dispositif de chargement 26 (figure 4E).

La figure 5 montre schématiquement le chargement de substrats 18 dans l'enceinte 34 d'un four de densification obtenu après avoir formé des empilements de modules unitaires 10. L'enceinte 26 est représentée schématiquement en pointillés. Le chargement de substrats 18 comprend une pluralité d'empilements de modules unitaires 10, dans cet exemple quatorze empilements sont présents dans l'enceinte 26. Chaque empilement de modules unitaires 10 comprend, dans cet exemple, sept modules unitaires 10.

Pour réaliser l'empilement d'un deuxième module unitaire 10 sur un premier module unitaire 10, on pose le plateau support 14 du deuxième module unitaire 10 sur la dernière cale 20 et l'extrémité libre 16b du cylindre 16 du premier module unitaire 10 inférieur en centrant les modules 10 selon le même axe Y. Le cylindre 16 du premier module unitaire 10 est ainsi en contact avec le plateau support 14 du deuxième module unitaire 10 de façon à reprendre la masse de ce dernier. Un ou plusieurs joints d'étanchéité peuvent être présents sur la face inférieure d'un plateau support 14 destiné à être au contact d'une extrémité libre 16b d'un cylindre et/ou sur l'extrémité libre du cylindre 16b destinée à être au contact d'un plateau support 14.

Dans un empilement de modules unitaires 10, les volumes internes 17 sont en communication par l'intermédiaire des ouvertures d'admission 14a de façon à former un conduit central qui permet l'acheminement d'un gaz sur toute la hauteur de l'empilement. Les volumes externes 19 sont aussi en communication par l'intermédiaire des ouvertures d'évacuation 14b de façon à former un conduit périphérique qui permet l'évacuation des gaz ayant traversé les substrats 18.

Chaque empilement de modules unitaires 10 est surmonté d'un couvercle 22 (figures 5 et 6) qui ferme le conduit central. Chaque couvercle 22 comprend des ouvertures d'évacuation de gaz 22a en communication avec le conduit périphérique de façon à permettre l'évacuation des gaz de l'enceinte 34.

A la base de chaque empilement de modules unitaires 10, un module unitaire 10 est en contact avec un fond 34a de l'enceinte 34 de façon à ce que son ouverture centrale d'admission 14a soit en communication avec une entrée de gaz 36 prévue dans le fond 34a et que les ouvertures d'échappement 14b de ce module 10 soient obstruées. Il y a, dans cet exemple, autant d'entrée de gaz 36 que d'empilement de modules unitaires 10 dans l'enceinte 34.

L'enceinte 34 comprend une paroi chauffée 34b qui constitue ici un suscepteur délimitant latéralement l'enceinte 34. Plus précisément, la paroi 34b est ici un induit qui est couplé inductivement avec un inducteur 38 présent autour de l'enceinte 34. Dans l'exemple illustré, le chargement de substrats poreux 18 est adapté à la forme cylindrique de l'enceinte 34 autour de l'axe X. En particulier les empilements de modules unitaires 10 sont répartis dans l'enceinte 10 autour de l'axe X.

Une fois le chargement réalisé, une phase gazeuse (ou gaz réactif) contenant un ou plusieurs constituants précurseur de carbone est introduite dans l'enceinte 34 au travers des entrées de gaz 36. La phase gazeuse introduire est acheminée, pour chaque empilement, jusqu'à l'ouverture centrale d'admission de gaz 14a du premier module unitaire 10 de l'empilement. La phase gazeuse arrive ensuite dans les volumes internes 17 formés par les passages centraux 18a des substrats 18. La différence de pression plus ou moins importante entre le conduit central de chaque empilement (correspondant à la réunion des volumes internes 17) et le conduit périphérique (correspondant à la réunion des volumes externes 19) assure que la phase gazeuse traverse les substrats 18 pour les densifier. Une fois que la phase gazeuse a traversé les substrats 18, elle atteint le conduit périphérique et peut être ensuite évacuée par les ouvertures d'évacuation 22a du couvercle 22. Les gaz évacués par les ouvertures 22a des couvercles 22 peuvent enfin être récupérés par une ouverture d'évacuation (non représentée) ménagée dans une paroi supérieure de l'enceinte 34, qui peut être associée éventuellement à des moyens d'aspiration.

Typiquement, la phase gazeuse comprend un gaz vecteur et un ou plusieurs précurseurs gazeux de matrice. Pour former une matrice carbonée on peut utiliser en tant que précurseur gazeux du méthane, du propane ou un mélange des deux. Le gaz vecteur peut être du gaz naturel.

## Revendications

1. Procédé de densification par infiltration chimique en phase gazeuse de substrats annulaires poreux (18), le procédé comprenant au moins les étapes suivantes :
- fournir une pluralité de modules unitaires (10), chaque module unitaire comprenant un plateau support (14) sur lequel est formée une pile de substrats annulaires poreux, le plateau support comprenant une ouverture centrale d'admission de gaz (14a) communiquant avec un volume interne (17) formé par les passages centraux (18a) des substrats empilés et des ouvertures d'évacuation de gaz (14b) réparties angulairement autour de l'ouverture centrale, et un cylindre (16) formant masse thermique disposé autour de la pile de substrat ayant une première extrémité (16a) solidaire du plateau support et une deuxième extrémité (16b) libre,
- former des empilements de modules unitaires dans l'enceinte (34) d'un four de densification, chaque empilement comprenant au moins un deuxième module unitaire empilé sur un premier module unitaire, le plateau support du deuxième module unitaire reposant sur la deuxième extrémité libre du cylindre du premier module unitaire, l'ouverture centrale d'admission de gaz (14a) du deuxième module unitaire communiquant avec le volume interne (17) de la pile de substrats du premier module unitaire, et les ouvertures d'évacuation de gaz (14b) du deuxième module unitaire communiquant avec un volume externe (19) à la pile de substrats du premier module unitaire, et
- injecter dans les empilements de modules unitaires une phase gazeuse comprenant un précurseur gazeux d'un matériau de matrice à déposer au sein de la porosité des substrats.

2. Procédé selon la revendication 1, dans lequel chaque cylindre (16) est en graphite.

3. Procédé selon la revendication 1 ou la revendication 2, dans lequel chaque module unitaire (10) comprend des cales (20) entre les substrats poreux (18), chaque cale ménageant un passage de fuite entre le volume interne (17) de la pile de substrats et le volume externe (19) à la pile de substrats.

4. Procédé selon l'une quelconque des revendications 1 à 3, dans lequel chaque plateau support (14) est de forme circulaire et présente un diamètre compris entre 110% et 120% du diamètre externe d'un substrat annulaire poreux.

5. Procédé selon l'une quelconque des revendications 1 à 4, dans lequel, pour former une pile de substrats annulaires poreux (18) sur le plateau support (14) d'un module unitaire (10), on insère des bras (30) d'un dispositif de chargement (26) dans le module unitaire par les ouvertures d'évacuation (14b) du plateau support, on forme la pile de substrats sur les extrémités des bras insérés dans le module unitaire, et on retire les bras du module unitaire de sorte à déposer la pile ainsi formée sur le plateau support.

6. Procédé selon l'une quelconque des revendications 1 à 5, dans lequel l'enceinte (34) du four de densification est délimitée par un suscepteur couplé à un inducteur (38).

7. Procédé selon l'une quelconque des revendications 1 à 6, dans lequel chaque substrat annulaire poreux (18) comprend du carbone.

8. Procédé selon l'une quelconque des revendications 1 à 7, dans lequel chaque substrat annulaire poreux (18) constitue une préforme fibreuse de disque de frein.

## Patentansprüche

1. Verfahren zur Verdichtung durch chemische Gasphaseninfiltration poröser ringförmiger Substrate (18), wobei das Verfahren mindestens die folgenden Schritte umfasst:
- Bereitstellen einer Vielzahl von Einzelmodulen (10), wobei jedes Einzelmodul eine Trägerplatte (14) umfasst, auf der ein Stoß poröser ringförmiger Substrate gebildet ist, wobei die Trägerplatte eine zentrale Gaseinlassöffnung (14a) umfasst, die mit einem inneren Volumen (17) kommuniziert, das von den zentralen Durchgängen (18a) der gestapelten Substrate gebildet ist, und Gasauslassöffnungen (14b), die winklig um die zentrale Öffnung verteilt sind, und einen Zylinder (16), der eine thermische Masse bildet, der um den Substratstoß angeordnet ist, der ein erstes Ende (16a), das mit der Trägerplatte fest verbunden ist, und ein freies zweites Ende (16b) hat,
- Bilden von Einzelmodulstapeln in der Kammer (34) eines Verdichtungsofens, wobei jeder Stapel mindestens ein zweites Einzelmodul umfasst, das auf ein erstes Einzelmodul gestapelt ist, wobei die Trägerplatte des zweiten Einzelmoduls auf dem freien zweiten Ende des Zylinders des ersten Einzelmoduls ruht, wobei die zentrale Gaseinlassöffnung (14a) des zweiten Einzelmoduls mit dem inneren Volumen (17) des Substratstoßes des ersten Einzelmoduls kommuniziert, und die Gasauslassöffnungen (14b) des zweiten Einzelmoduls mit einem zum Substratstoß des ersten Einzelmoduls externen Volumen (19) kommunizieren, und
- Einleiten, in die Einzelmodulstapel, einer Gasphase, die einen gasförmigen Vorläufer eines innerhalb der Porosität der Substrate anzuordnenden Matrixmaterials umfasst.

2. Verfahren nach Anspruch 1, wobei jeder Zylinder (16) aus Graphit ist.

3. Verfahren nach Anspruch 1 oder Anspruch 2, wobei jedes Einzelmodul (10) Keile (20) zwischen den porösen Substraten (18) umfasst, wobei jeder Keil einen Leckdurchgang zwischen dem inneren Volumen (17) des Substratstoßes und dem zum Substratstoß externen Volumen (19) ausbildet.

4. Verfahren nach einem der Ansprüche 1 bis 3, wobei jede Trägerplatte (14) kreisförmig ist und einen Durchmesser aufweist, der zwischen 110% und 120% des Außendurchmessers eines porösen ringförmigen Substrats liegt.

5. Verfahren nach einem der Ansprüche 1 bis 4, wobei, um einen Stoß poröser ringförmiger Substrate (18) auf der Trägerplatte (14) eines Einzelmoduls (10) zu bilden, Arme (30) einer Ladevorrichtung (26) in das Einzelmodul durch die Auslassöffnungen (14b) der Trägerplatte eingeführt werden, der Substratstoß auf den Enden der in das Einzelmodul eingeführten Arme gebildet wird und die Arme des Einzelmoduls derart zurückgezogen werden, dass der derart gebildete Stoß auf der Trägerplatte angeordnet wird.

6. Verfahren nach einem der Ansprüche 1 bis 5, wobei die Kammer (34) des Verdichtungsofens durch einen an einen Induktor (38) gekoppelten Suszeptor begrenzt ist.

7. Verfahren nach einem der Ansprüche 1 bis 6, wobei jedes poröse ringförmige Substrat (18) Kohlenstoff umfasst.

8. Verfahren nach einem der Ansprüche 1 bis 7, wobei jedes poröse ringförmige Substrat (18) eine Faservorform einer Bremsscheibe darstellt.

## Claims

1. A process for densifying annular porous substrates (18) by chemical vapour infiltration, the process comprising at least the following steps:
- providing a plurality of unit modules (10), each unit module comprising a support plate (14) on which is formed a stack of annular porous substrates, the support plate comprising a central gas inlet opening (14a) communicating with an internal volume (17) formed by the central passages (18a) of the stacked substrates and gas outlet openings (14b) angularly distributed around the central opening, and a thermal mass cylinder (16) disposed around the stack of substrates having a first end (16a) integral with the support plate and a second free end (16b),
- forming stacks of unit modules in the chamber (34) of a densification furnace, each stack comprising at least one second unit module stacked on a first unit module, the support plate of the second unit module resting on the second free end of the cylinder of the first unit module, the central gas inlet opening (14a) of the second unit module communicating with the internal volume (17) of the stack of substrates of the first unit module, and the gas outlet openings (14b) of the second unit module communicating with an external volume (19) to the stack of substrates of the first unit module, and
- injecting into the stacks of unit modules a gas phase comprising a gas precursor of a matrix material to be deposited within the porosity of the substrates.

2. The process as claimed in claim 1, wherein each cylinder (16) is made of graphite.

3. The process as claimed in claim 1 or claim 2, wherein each unit module (10) comprises shims (20) between the porous substrates (18), each shim providing a leakage passage between the internal volume (17) of the stack of substrates and the external volume (19) to the stack of substrates.

4. The process as claimed in any one of claims 1 to 3, wherein each support plate (14) is circular in shape and has a diameter comprised between 110% and 120% of the outer diameter of an annular porous substrate.

5. The process as claimed in any one of claims 1 to 4, wherein, to form a stack of annular porous substrate (18) on the support plate (14) of a unit module (10), arms (30) of a loading device (26) are inserted into the unit module through the outlet openings (14b) of the support plate, the stack of substrates is formed on the ends of the arms inserted into the unit module, and the arms are removed from the unit module so as to deposit the stack thus formed on the support plate.

6. The process as claimed in any one of claims 1 to 5, wherein the chamber (34) of the densification furnace is delimited by a susceptor coupled to an inductor (38).

7. The process as claimed in any one of claims 1 to 6, wherein each annular porous substrate (18) comprises carbon.

8. The process as claimed in any one of claims 1 to 7, wherein each annular porous substrate (18) constitutes a fibrous preform for a brake disc.
